# EUROPÄISCHE PATENTSCHRIFT

(11) **EP 0 710 402 B1**
(45) Veröffentlichungstag und Bekanntmachung des Hinweises auf die Patenterteilung: **18.10.2006**
(21) Anmeldenummer: 94920402.8
(22) Anmeldetag: 12.07.1994
(51) Int. Cl.: H01L 27/142, H01L 31/20

(54) **INTEGRIERTES LASERSTRUKTURIERUNGSVERFAHREN FÜR DÜNNFILMSOLARZELLEN**
INTEGRATED LASER STRUCTURING PROCESS FOR THIN FILM SOLAR CELLS
PROCEDE DE STRUCTURATION LASER INTEGREE POUR PILES SOLAIRES EN COUCHE MINCE

(30) Priorität: 20.07.1993 DE 4324318
(43) Veröffentlichungstag der Anmeldung: 08.05.1996
(73) Patentinhaber: Shell Solar GmbH, 81739 München (DE)
(72) Erfinder: KARG, Franz, D-81671 München (DE); RIEDL, Wolfgang, D-80634 München (DE); EINZINGER, Richard, D-85643 Steinhöring (DE); AULICH, Hubert, D-81669 Müchen (DE)
(74) Vertreter: Zeestraten, Albertus W. J.
(86) Internationale Anmeldenummer: PCT/DE1994/000803
(87) Internationale Veröffentlichungsnummer: WO 1995/003628

(56) Entgegenhaltungen:
- EP-A- 0 457 312
- EP-A- 0 536 431
- US-A- 4 517 403
- US-A- 4 675 467
- US-A- 4 755 475
- US-A- 4 954 181
- US-A- 4 968 354

## Beschreibung

Dünnfilmsolarzellen sind aus kostengünstigen amorphen oder polykristallinen Halbleitermaterialien aufgebaut, die sich auf großflächigen Substraten abscheiden oder erzeugen lassen. Durch photovoltaische Umwandlung von Sonnenenergie in elektrische Leistung erzeugen solche Solarzellen Spannungspegel von unter 1 Volt. Um eine technisch verwertbare Leistung bei einer Spannung von typisch 12 Volt oder 24 Volt zu erhalten, werden mehrere Einzelsolarzellen in Serie geschaltet. Bei Dünnfilmsolarzellen kann diese Serienverschaltung in den Schichtherstellungsprozeß integriert werden. Die Basiselektrode, die Solarzelle und die Rückelektrode werden im Anschluß an die jeweils ganzflächig erfolgende Beschichtung mittels geeigneter Strukturierungsverfahren in Längsstreifen unterteilt. Ziel der Strukturierung ist es, eine elektrische Verbindung zwischen Vorder- und Rückseite benachbarten streifenförmiger Einzelzellen zu schaffen.

Die bisher bekannten Strukturierungsverfahren für Dünnfilmsolarzellen sind den jeweiligen Dünnfilmhalbleitermaterialien angepaßt, deren wichtigste Vertreter amorphes Silizium a-Si:H, Kupfer-Indium-Diselenid CuInSe₂ und Cadmium-Tellurid CdTe sind.

Die Verfahren unterscheiden sich im wesentlichen nach
a) mechanischen und Laser-Bearbeitungsverfahren sowie
b) Pastenschreibmethoden und Lift-off-Techniken.

Mechanische Verfahren zeigen den Nachteil kurzer Standzeiten des Werkzeugs und relativ breiter Strukturierungsgräben von ca. 0,5 mm und mehr, die stets mit einem Verlust an aktiver Solarzellenfläche verbunden sind. Auch die unter b) genannten Verfahren führen zu breiten Strukturierungsgräben, die die erzielbare Gesamtleistung der Solarzelle bzw. des Solarzellenmoduls erniedrigen.

Die Probleme der Laserbearbeitung liegen in der häufig nicht kontrollierbaren Selektivität des Schichtabtrags und der dadurch bewirkten partiellen Erwärmung des gesamten Schichtaufbaus. Der Materialabtrag konnte bislang schlecht auf eine der Elektroden oder das Halbleitermaterial beschränkt werden. Beim Abtrag des Halbleitermaterials selbst besteht außerdem die Gefahr, in der Nachbarschaft der Strukturierungsgräben unerwünschte Beschädigungen und Veränderungen der Halbleiterschicht zu erzeugen, die zu einem Kurzschluß oder einer anderweitigen Verminderung der elektrischen Leistungsfähigkeit des Solarmoduls führen.

Aus der US-A-4 954 181 ist ein Verfahren zur integrierten Serienverschaltung von Dünnschichtsolarmodulen bekannt. Die Auftrennung der Einzelsolarzellen bzw. die Strukturierung der Halbleiterschicht erfolgt dabei mit einem Laser mit einer ersten Energiedichte. Die Serienverschaltung erfolgt durch Erzeugung niederohmiger Bereiche mittels Phasenumwandlung mit Hilfe eines Lasers bei niedrigerer Energiedichte.

In der US-Patentschrift US 4 675 467 ist ein Verfahren zur Serienverschaltung eines Dünnfilmsolarmoduls angegeben, welches auf die Strukturierung der Halbleiterschicht verzichtet. Die Elektrodenstreifen der strukturierten Rückelektrode weisen Überlappungsbereiche mit dem Elektrodenstreifen der Frontelektrode der jeweils benachbarten Solarzelle auf. Mit Hilfe energiereicher Strahlung wird das Halbleitermaterial in diesem Überlappungsbereich in eine elektrisch gut leitende Phase umgewandelt, wobei sich eine Serienverschaltung der durch die streifenförmigen Elektroden definierten Einzelsolarzellen ergibt. Nachteilig an dieser Struktur ist, daß die Halbleitermaterialien benachbarter Einzelsolarzellen nicht elektrisch gegeneinander isoliert sind, so daß stets ein die verwertbare elektrische Leistung mindernder Pfad für einen Kurzschlußstrom horizontal quer zur Strukturierungsrichtung entsteht. Ungelöst bleibt dabei das Problem, die Rückelektrode in einem schmalen Strukturierungsschritt ohne Schädigung des Halbleitermaterials zu trennen.

Aufgabe der vorliegenden Erfindung ist es daher, ein Verfahren zur integrierten Strukturierung einer Dünnfilmsolarzelle anzugeben, mit dem es möglich ist, schmale Strukturierungsstreifen bzw. -gräben zu erzeugen, die Einzelsolarzellen vollständig gegeneinander elektrisch zu isolieren und bei dem die einzelnen Strukturierungsschritte selektiv, gut kontrollierbar und damit reproduzierbar durchzuführen sind. Außerdem soll der Strukturierungsaufwand reduziert werden.

Diese Aufgabe wird erfindungsgemäß gelöst durch ein Verfahren nach Anspruch 1. Weitere Ausgestaltungen der Erfindung sind den Unteransprüchen zu entnehmen.

Mit dem erfindungsgemäßen Verfahren wird eine gute elektrische Isolierung der photovoltaisch aktiven Schichten der einzelnen Solarzellenstreifen gegeneinander erzeugt. Ein Kurzschluß zwischen benachbarten Solarzellenstreifen wird weitestgehend vermieden, da durch die erste Laserbestrahlung eine vollständige und saubere Abhebung des Halbleitermaterials im bestrahlten Bereich samt darüberliegender Rückelektrode erfolgt.

Zusammen mit der zweiten Bestrahlung wird eine sichere Serienverschaltung benachbarter Solarzellenstreifen erzeugt, die ohne zusätzlichen Materialauftrag oder -abtrag ermöglicht wird. Damit entfällt eine zusätzliche Strukturierung der Rückelektrode, wie sie etwa im Verfahren nach der US 4 675 467 erforderlich ist. Die dort auftretenden Selektivitätsprobleme bei der Strukturierung der Rückelektrode gegenüber der Halbleiterschicht oder zu breite Strukturierungsstreifen bei bisher bekannten sicheren Strukturierungsverfahren werden dadurch vermieden.

Strukturierung und Verschaltung der Solarzellen können mittels eines einzigen Werkzeugs bzw. in einer einzigen Anlage erfolgen. Die beiden dazu erforderlichen Bestrahlungen können unmittelbar hintereinander durchgeführt werden. Vorteilhafterweise werden beide synchron nebeneinander durchgeführt. Dabei ist es möglich, die beiden Bestrahlungen mittels eines einzigen Laserstrahls mit einem asymmetrischen Strahlprofil durchzuführen. Die Intensitätsverteilung dieses Lasers senkrecht zur Strukturierungsrichtung ist dabei so, daß in einem ersten Bereich eine Absprengung der Halbleiterschicht, in einem zweiten, direkt benachbarten Bereich jedoch nur Erhitzung und Phasenumwandlung der Halbleiterschicht zur Bildung des niederohmigen Bereichs erfolgen.

Das Verfahren ist für sämtliche Halbleitermaterialien geeignet, die photovoltaisch einsetzbar sind, das heißt für alle Halbleiter mit einem geeigneten Bandabstand zwischen 0,5 und 2 eV, die außerdem ein Absorptionsverhalten zeigen, welches sich von dem bekannter transparenter Elektrodenmaterialien so deutlich unterscheidet, daß eine sichere Durchführung des erfindungsgemäßen Verfahrens möglich ist.

Da die Phasenumwandlung des zweiten Bereichs unmittelbar neben der in der ersten Laserbehandlung erzeugten Strukturlücke erfolgt, ist ein ungehindertes Ausgasen der durch die Phasenumwandlung freiwerdenden gasförmigen Verbindungen möglich.

Im folgenden wird die Erfindung anhand von fünf Figuren und zwei Ausführungsbeispielen näher erläutert.

In den Figuren 1 bis 3 sind verschiedene Verfahrensstufen bei der Herstellung, Strukturierung und Verschaltung einer Dünnfilmsolarzelle anhand von nicht maßstabsgetreuen schematischen Querschnitten dargestellt, während

Figur 4 ein fertig verschaltetes Solarmodul in der Draufsicht zeigt.

Figur 5 zeigt eine spezielle Strahlführung zur synchronen Durchführung der beiden Bestrahlungen.

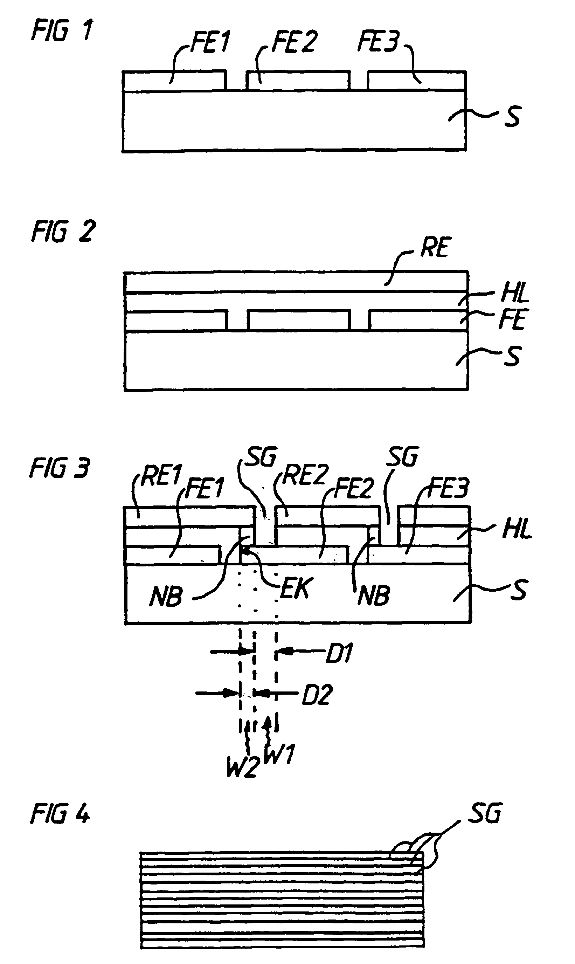

Figur 1: Als Substrat S für die Solarzelle wird ein beliebiges transparentes Material verwendet, welches gegenüber den Verfahrensbedingungen der einzelnen Prozeßschritte inert ist, beispielsweise Glas. Das Substrat kann auch semitransparent für die Wellenlänge des zur Strukturierung verwendeten Lasers sein. Nach bekannter Vorbehandlung des Substrats S wird darauf ganzflächig eine transparente Frontelektrodenschicht FE aufgebracht. Je nach Art des späteren Halbleitermaterials kann diese aus beliebigen, gegebenenfalls dotierten elektrisch leitenden Metalloxiden (TCO) bestehen, beispielsweise aus Zinnoxid SnO₂, Zinkoxid ZnO, Indiumzinnoxid oder anderen. Die Schichtdicke richtet sich nach der erforderlichen bzw. gegebenen spezifischen Leitfähigkeit der Elektrodenschicht und beträgt beispielsweise 1 µm. Durch ein beliebiges Strukturierungsverfahren wird die Frontelektrodenschicht FE in eine Anzahl zueinander paralleler Elektrodenstreifen aufgeteilt, von denen in der Figur der Übersichtlichkeit halber nur drei dargestellt sind (FE1, 2, 3).Die Strukturierung kann beispielsweise durch Laserschreiben, Abhebetechnik oder mechanisches Ritzen erfolgen.

Figur 2: Über den Elektrodenstreifen FE1 bis 3 wird nun ganzflächig eine photovoltaisch aktive Dünnfilmhalbleiterschicht HL abgeschieden. Diese besteht im einfachsten Fall aus einem Absorber, das heißt einem Halbleiter mit einem Bandabstand zwischen 0,5 eV und 2 eV, um einen möglichst großen Anteil der Sonnenstrahlung zu absorbieren. Eventuell zusätzlich umfaßt die Halbleiterschicht HL entsprechend dotierte Schichtbereiche zur Ausbildung einer Raumladungszone. Die zur Ladungsträgertrennung notwendige Bandverbiegung bzw. der pn-Übergang kann durch zusätzliche Dotierung eines Schichtbereichs mit Dotierstoffen eines zweiten Leitfähigkeitstyps erzeugt werden. Möglich ist es auch, einen Heteroübergang durch Abscheiden einer weiteren Halbleiterschicht zu erzeugen, oder den Heteroübergang durch Kombination der Absorberschicht mit einer geeigneten Frontelektrode auszubilden.

Über der photovoltaisch aktiven Halbleiterschicht HL wird nun ganzflächig eine Rückelektrodenschicht RE aufgebracht. Diese kann aus einer opaquen Metallelektrodenschicht oder einer zweiten transparenten Elektrodenschicht bestehen. Die sichere Durchführung des erfindungsgemäßen Verfahrens ist praktisch nicht von der speziellen Ausbildung bzw. der Art der Rückelektrodenschicht RE abhängig.

Im Anschluß an diese Schichterzeugungs- und das Elektrodenstrukturierungsverfahren erfolgen nun die zwei entscheidenden Schritte zur integrierten Strukturierung und Verschaltung der Solarzelle.

Figur 3: In einem schmalen Bereich D1 in der Nähe und parallel zu einer Kante der Frontelektroden FE wird nun von der Substratseite her eine erste Laserbestrahlung W1 durchgeführt. Dazu wird ein gepulster Laser mit einer geeigneten Lichtwellenlänge λ1 verwendet, die in der Frontelektrode FE überwiegend transmittiert, in der Halbleiterschicht HL jedoch stark absorbiert wird. Dies führt zu einer starken Erwärmung des Absorbers bzw. der Halbleiterschicht im Bereich D1 und zu einer mechanischen Verspannung. Bei geeigneter Bemessung von Pulslänge und Energiedichte der Strahlung führt dies zum anschließenden Abplatzen der Halbleiterschicht samt darüberliegender Rückelektrode RE im Bereich D1. Dabei ist klar, daß die Wellenlänge λ1, die Pulslänge und die Energiedichte nicht unabhängig voneinander gewählt werden können, sondern auf das Absorptionsverhalten des Halbleiters abgestimmt sind. Bei optimaler Fokussierung verbleibt über der Frontelektrode FE ein Strukturgraben SG im Bereich D1, in dem Halbleiterschicht und Rückelektrode vollständig entfernt sind. Ein solches Laserstrukturierungsverfahren ist in der EP-A-0536431 beschrieben.

Diese erste Laserbestrahlung W1 kann so durchgeführt werden, daß in den nicht abgesprengten benachbarten Bereichen der Halbleiterschicht HL nur eine geringfügige Erwärmung des Halbleitermaterials beobachtet wird. Für solch eine Verfahrensführung wird ein Laser mit annähernd radialem Strahlprofil verwendet, bei dem die Intensität der Strahlung nach außen hin steil abfällt.

Zwischen dem erzeugten Strukturgraben SG und der benachbarten Kante EK der Frontelektrode verbleibt ein von Null verschiedener Abstand, der mindestens der Breite des zweiten Bereichs D2 entspricht. In diesem Bereich überlappt ein Streifen der Rückelektrode RE den jeweils benachbarten Streifen der Frontelektrode FE. Im Bereich dieser Überlappung wird nun im Bereich D2 eine zweite Laserbestrahlung W2 von der Substratseite her durchgeführt. Wellenlänge λ2, Intensität und gegebenenfalls die Länge der Impulse (bei gepulster Bestrahlung) dieser zweiten Bestrahlung sind so bemessen, daß das in seiner Phase umzuwandelnde Halbleitermaterial HL im Schichtverbund erhalten bleibt, keine Ablösungen oder Risse entstehen und durch Wirkung der Wärmeleitung homogen im belichteten Bereich sowie höchstens auf der Breite D2 des zu erzeugenden Kontaktgrabens erwärmt wird. Die Energie wird so bemessen, daß durch Phasenumwandlung des Halbleitermaterials im bestrahlten Bereich ein niederohmiger Bereich NB entsteht, der gegenüber der Halbleiterschicht HL eine deutlich erhöhte Leitfähigkeit zeigt. Damit wird also eine elektrisch gut leitende Verbindung zwischen der Rückelektrode RE1 einer ersten Solarzelle und mit der Frontelektrode FE2 einer zweiten Solarzelle und deren Rückelektrode RE2 mit der Frontelektrode FE3 der nächsten Solarzelle usw. hergestellt, wobei sich in einfacher Weise eine Serienverschaltung dieser Solarzellen ergibt.

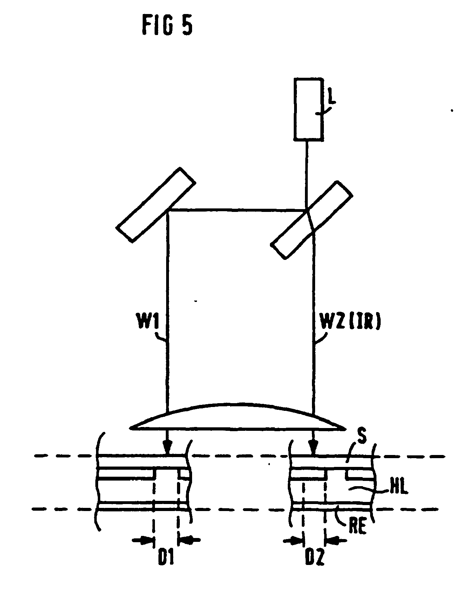

Der Unterschied zwischen erster Laserbestrahlung W1 und zweiter Bestrahlung W2 liegt in der absorbierten Eriergiedichte und in der zeitlichen Pulslänge der beiden belichtenden Strahlungen, sowie in deren Wellenlängen. Entscheidend für die Bestrahlung W1 ist die Absprengung der Schichten, also eine Energieeinkopplung mit geeigneter Mindest-Energiedichte sowie Mindest-Bestrahlungsfläche. Für die Bestrahlung W2 ist das defektfreie Verbleiben der belichteten Schicht im Schichtverband sowie eine für die Phasenumwandlung ausreichende Strahlungsabsorption entscheidend. Dementsprechend kann die absorbierte Energie durch verschiedene Parameter beeinflußt werden. Hierbei lassen sich mehrere Fallkombinationen anführen:
- Werden die beiden Bestrahlungen W1 und W2 mit demselben gepulsten Laser und derselben Wellenlänge ausgeführt, so müssen sich die Intensitäten deutlich voneinander unterscheiden. Die Energiedichte und die belichtete Fläche müssen bei W1 jeweils kritische Schwellen überschreiten (siehe EPA-A-0536431), bei W2 unterschreiten, wobei zur sicheren Ausführung von W2 besonders die Energiedichte unterschwellig sein muß. Diese Fallkombination ist nicht Teil der Erfindung.
- Bei Verwendung verschiedener Wellenlängen können für W1 und W2 spezifische Optima gewählt werden. Für W1 ist eine in der Regel kurze Wellenlänge von Vorteil, die im Halbleiter HL möglichst stark absorbiert wird. W2 kann geeignet optimiert werden durch Wahl einer Wellenlänge λ2, die weniger stark absorbiert wird und deshalb im HL eine größere Eindringtiefe erfährt. Um starke Absorption auch größerer Wellenlängen zu vermeiden wird man hierbei auf Laserimpulse von ns und größeren Dauern angewiesen sein.
- In einer besonderen Ausgestaltung dieses Anwendungsfalls ist es möglich, für W1 die frequenzverdoppelte Strahlung eines Nd : YAG oder Nd : YLF-Lasers L zu verwenden und auf D1 zu fokussieren, während für W2 der nichtkonvertierte Anteil der IR-Grundwellenlänge aus der Strahlung ausgekoppelt und separat in einen Bereich D2 der Moduloberfläche fokussiert wird. In diesem Fall wird die stets langwellige Strahlung, die bei der Frequenzverdopplung mit naturgemäß endlichem Wirkungsgrad stets im Strahlengang enthalten ist, durch Ausblenden mit einer geeigneten optischen Anordnung effektiv verwendet. Das Schema eines geeigneten optischen aufbaus in in Abbildung 5 wiedergegeben. Der Vorteil dieser Anwendung liegt in der Möglichkeit eines Zweistrahlbetriebs mit für W1 und W2 optimalen Wellenlängen unter Verwendung eines einzigen geeigneten Lasers.
- Es erscheint prinzipiell möglich, die beiden Belichtungen mit einem einzigen Laserstrahl zu erzeugen, wenn das Strahlprofil für W1 gleichförmig und optimal für die Schichtenabtragung justiert wird, während W2 durch eine einseitige optische Defokussierung des Strahls entsteht.

Während für W1 stets ein gepulster Laserstrahl zur Verfügung stehen muß, kann W2 alternativ mit einem Dauerstrich-Laserstrahl (cw) oder mit dem fokussierten Licht einer Lampe erzeugt werden. Intensität und Rastergeschwindigkeit des cw-Laserstrahls müssen so optimiert werden, daß die belichtete Halbleiterschicht HL nur kurzzeitig und in Maßen erwärmt wird, damit sie sich weder ablöst noch die aktive Solarzellenfläche beeinträchtigt wird. Gleiches gilt bei Verwendung einer intensiven Lampe, deren Licht in einem besonderen Anwendungsfall mit Hilfe einer Zylinderlinse streifenförmig auf den Bereich D2 fokussiert werden kann. Dadurch wird eine hohe Rastergeschwindigkeit möglich.

Für das Verfahren und das Ergebnis ist es unbedenklich, wenn die zweite Bestrahlung auch den Bereich D1 der ersten Bestrahlung mit erfaßt. Bei gleicher Fokussierung kann so ein besonders schmaler niederohmiger Bereich NB erzeugt werden, der einen geringeren Verlust an aktiver Solarzellenfläche erzeugt.

Im folgenden werden zwei beispielhafte Dünnfilmsolarzellentypen angegeben, die sich mit dem erfindungsgemäßen Verfahren in besonders vorteilhafter Weise strukturieren und verschalten lassen.

Eine Dünnfilmsolarzelle auf der Basis einer amorphen Silizium ₍₁₋ₓ₎-Germanium ₍ₓ₎-Wasserstofflegierung (0 ≤ x < 1) läßt sich erfindungsgemäß mit einem blauen oder grünen Laser strukturieren. Gut geeignet ist beispielsweise ein Frequenz verdoppelter Nd:YAG- oder Nd:YLF-Laser, der für die erste Laserbehandlung auf eine Pulslänge von unter 200 ns, insbesondere jedoch auf eine Pulslänge zwischen 20 ns und 100 ps eingestellt wird. Eine radiale Intensitätsverteilung des Laserstrahls mit einem Gaußprofil wird erreicht, wenn für das Verfahren die TEM₀₀-Mode verwendet wird. Möglich ist es auch, ein radiales Strahlprofil zu wählen, dessen Intensität am Rand steil abfällt.

Im Fall gepulster Strahlung für W2 ist das Unterschreiten der Abtragungsschwelle zuachten. Daraus ergeben sich die geeigneten Parameter in strenger Abhängigkeit von W1. Die Deposition von ca. 100 µJ in D2 auf einer Breite von 50 bis 100 µm gilt als ausreichend für eine Phasenumwandlung in a-Si:H und in Chalcopyrit-Halbleitern. Dies ist einer Belichtung mit einem Dauerstrich-Laserstrahl von 1 mW und einer Rastergeschwindigkeit von 1 mm/s äquivalent.

Bei dieser zweiten Strahlenbehandlung W2erfährt die Halbleiterschicht eine Erwärmung und durchläuft dabei eine Phasenumwandlung zu hochleitendem mikrokristallinen Silizium-Germanium, wobei gasförmiger Wasserstoff freigesetzt wird. Über den unmittelbar benachbarten Strukturgraben SG kann der Wasserstoff ungehindert aus der Halbleiterschicht bzw. aus der gesamten Solarzellenstruktur entweichen. Anders als bei der genannten US 4 675 467 kann sich dabei also kein Gasdruck innerhalb der Solarzelle aufbauen, der zu Schichtablösungen und in deren Folge zur Beschädigung oder gar Zerstörung der Solarzelle führt.

Dünnfilmsolarzellen auf der Basis von Chalkopyrit-Halbleitern der Zusammensetzung CuIn₁₋ₓGaₓ(S_{1-y}Se_{y})₂ (0 ≤ x,y ≤ 1) wie beispielsweise Kupfer-Indium-Diselenid CuInSe₂ lassen sich mit dem gleichen Laser wie die genannte Siliziumlegierung in der ersten Laserbehandlung strukturieren. Auch die zweite Bestrahlung wird in analoger Weise durchgeführt, wobei durch Erhitzen der Halbleiterschicht (zum Beispiel aus der ternären Verbindung CuInSe₂) flüchtige Selenverbindungen, insbesondere Indiumselenid InSe in gasförmiger Form ausgetrieben werden. Dabei reichert sich die Halbleiterschicht im bestrahlten Bereich mit hochleitendem binären Kupferselenid Cu₂Se oder Cu₂S an, so daß der gesamte bestrahlte Bereich niederohmig wird. Auch hier können die erzeugten gasförmigen Verbindungen ungehindert über den benachbarten Strukturgraben SG aus der Solarzellenstruktur entweichen.

Mit dem erfindungsgemäßen Verfahren lassen sich schmale Strukturgräben SG erzeugen, die einen nur minimalen Verlust an aktiver Solarzellenfläche bedeuten. Parasitäre Stromkanäle in lateraler Richtung (quer zum Strukturgraben SG) werden durch die vollständige Isolierung benachbarter Solarzellenstreifen vermieden. Diese würden bei der entsprechenden Streifenzelle zu einem Parallelleitwert führen, der insbesondere bei gut leitenden Solarzellenmaterialien, beispielsweise bei polykristallinen Absorbermaterialien zu Wirkungsgradeinbußen führt.

Figur 4 zeigt eine erfindungsgemäße strukturierte Dünnfilmsolarzelle in der Draufsicht. Die streifenförmigen miteinander in Serie verschalteten Einzelsolarzellen sind durch die Strukturgräben SG voneinander getrennt. Üblicherweise wird die Anzahl der Streifen durch die gewünschte Höhe der durch die Serienverschaltung zu erzielenden Gesamtspannung bestimmt. Die Breite der Streifen ist dann durch die Größe des verwendeten Substrats S festgelegt.

Gemäß dem erfindungsgemäßen Verfahren wird eine Dünnfilmsolarzelle bei ihrer Herstellung nur zweimal einer Strukturierung unterworfen. Dies ist zunächst die unkritische Strukturierung der Frontelektrode FE und die zum Abschluß des Verfahrens erfolgende erste und zweite (Laser)-Bestrahlung, die in einem oder zwei Schritten, auf jeden Fall aber in einer Anlage durchgeführt werden kann. Dies ist auch deshalb von Vorteil, weil sämtliche Schichtabscheideprozeduren für aktive Halbleiterschicht und Rückelektrode hintereinander durchgeführt werden können, ohne daß die Dünnfilmsolarzelle zwischendurch aus der gegebenenfalls ein Vakuum erfordernden Anlage für die Schichtabscheidung oder -erzeugung herausgenommen werden muß. Dadurch wird nicht nur die Solarzellenstruktur verbessert (schmälere Strukturgräben SG, sichere Isolierung der Halbleiterschichten der Streifensolarzellen gegeneinander, saubere Strukturierungskanten, keine Probleme mit Schichtablösung und Schädigungen von Solarzellenbereichen in direkter Nachbarschaft des Strukturierungsschrittes), sondern auch das Verfahren deutlich erleichtert und verkürzt. Dies erlaubt eine kostengünstigere Herstellung der Solarzelle.

## Patentansprüche

1. Verfahren zur Serienverschaltung einer Dünnfilmsolarzelle mit den Schritten
a) ganzflächiges Abscheiden einer transparenten Vorderseitenelektrode (FE) auf einem transparenten Substrat (S)
b) Unterteilung der Elektrodenschicht (FE) in n-Elektrodenstreifen (FE1, 2 ... n)
c) ganzflächiges Abscheiden einer photovoltaisch aktiven Dünnfilmhalbleiterschicht (HL)
d) ganzflächiges Abscheiden einer Rückelektrode (RE)
e) Durchführen einer ersten Laserbestrahlung (W1) der Halbleiterschicht (HL) durch das Substrat (S) und die Elektrodenstreifen (FE1, 2 ...) parallel zu und in der Nähe von einer Kante (EK) der Elektrodenstreifen (FE1, 2...) bei einer Wellenlänge (λ1), für die die Halbleiterschicht eine starke Absorption zeigt, wobei in einem ersten Bereich (D1) ein schmaler Streifen der Halbleiterschicht (HL) samt darüberliegender Rückelektrode (RE) abgesprengt und eine streifenförmige Strukturierung der Halbleiterschicht entsprechend den Elektrodenstreifen (FE1, ...n) erhalten wird,
f) Durchführen einer zweiten Bestrahlung (W2) der Halbleiterschicht von der Substratseite her mit einer von der ersten Laserbestrahlung (W1) verschiedenen Wellenlänge (λ2), für die die Halbleiterschicht (HL) eine niedrigere Absorption aufweist als für λ1 in einem zweiten Bereich (D2), der zwischen dem Bereich D1 und der genannten Kante (EK) liegt, in dem die Rückelektrode (RE) mit dem jeweils benachbarten Elektrodenstreifen (FE) der Frontelektrode überlappt, derart daß sich durch Phasenumwandlung in der Halbleiterschicht ein niederohmiger Bereich (NB) zwischen dem Elektrodenstreifen (FE) der Frontelektrode und der Rückelektrode (RE) ausbildet.

2. Verfahren nach Anspruch 1,
bei dem die zweite Bestrahlung mit einem Laser bei einer Wellenlänge (λ2) durchgeführt wird, wobei die Halbleiterschicht (HL) für λ1 eine höhere Absorption aufweist als für λ2.

3. Verfahren nach Anspruch 1 oder 2,
bei dem für die erste und die zweite (Laser)bestrahlung (W2) ein frequenzverdoppelter Nd:YAG oder Nd:YLF Laser (L) verwendet wird, wobei für die zweite Bestrahlung (W2) der nicht konvertierte Anteil des IR-Grundwellenlänge des Lasers (L) verwendet wird, und wobei dieser Anteil aus dem Strahlengang für die erste Laserbestrahlung (W1) ausgekoppelt wird.

4. Verfahren nach Anspruch 1,
bei dem die zweite Bestrahlung (W2) mit einer Lampe durchgeführt wird, deren Licht mit Hilfe einer Zylinderlinse streifenförmig fokussiert wird.

5. Verfahren nach einem der Ansprüche 1 bis 4,
bei dem im Verfahrensschritt c) eine amorphe wasserstoffhaltige Silizium/Germanium-Legierung a-Si₁₋ₓ Geₓ : H (1 > x ≥ 0) als Halbleiterschicht (HL) aufgebracht wird, und bei dem die zweite Bestrahlung (W2) so durchgeführt wird, daß die Phasenumwandlung unter Ausgasen von Wasserstoff zu einer mikrokristallinen Silizium/Germanium-Legierung Si₁₋ₓ Geₓ führt.

6. Verfahren nach einem der Ansprüche 1 bis 4,
bei dem als Halbleiterschicht (HL) eine Chalkopyrit-Schicht der Zusammensetzung CuIn₁₋ₓGaₓ(S_{1-y}Se_{y})₂ (0 ≤ x, y ≤ 1) erzeugt wird und bei dem die zweite Bestrahlung so durchgeführt wird, daß sich durch Ausgasen flüchtiger Selenverbindungen binäres Cu₂Se oder Cu₂S unter Bildung des niederohmigen Bereichs (NB) der Halbleiterschicht (HL) anreichert.

## Claims

1. Method of series connecting a thin film solar cell, comprising the steps of
a) depositing of a transparent front side electrode (FE) over the whole face onto a transparent substrate (S)
b) subdividing the electrode layer (FE) into n-electrode strips (FE1, 2 ... n)
c) depositing of a photovoltaic active thin film semi-conductor layer (HL) over the whole face
d) depositing of a back electrode (RE) over the whole face
e) carrying out a first laser irradiation (W1) of the semi-conductor layer (HL) through the substrate (S) and the electrode strips (FE1, 2 ...) in parallel to and in the vicinity of an edge (EK) of the electrode strips (FE1, 2 ...) at a wave length (λ1), for which the semi-conductor layer shows strong absorption, whereby in a first zone (D1) a narrow strip of the semi-conductor layer (HL) including the back electrode (RE) laying above are blasted-off and a strip-like structuring of the semi-conductor layer corresponding to the electrode strips (FE1, ... n) is obtained,
f) carrying out a second irradiation (W2) of the semi-conductor layer from the side of the substrate with a wave length (λ2), which is different from the wave length of the first laser irradiation (W1), for which the semi-conductor layer (HL) shows a lower absorption than for λ1 in a second area (D2), which lies between the area (D1) and the said edge (EK), in which the back electrode (RE) overlaps with each of the neighbouring electrode strips (FE) of the front electrode, such that, by a phase transformation in the semi-conductor layer low ohmic area (NB) is formed between the electrode strips (FE) of the front electrode and the back electrode (RE).

2. Method according to claim 1, in which the second irradiation with a laser is carried out with a wave length λ2, the semi-conductor layer (HL) having a higher absorption for λ1 than for λ2.

3. Method according to claim 1 or 2, in which for the first and the second (laser) irradiation (W2) a frequency doubled Nd:YAG or Nd:YLF laser (L) is used, whereby for the second irradiation (W2) the non-converted component of the IR-basic wave length of the laser (L) is used, and whereby this component is decoupled from the radiation path for the first laser irradiation (W1).

4. Method according to claim 1, in which the second irradiation (W2) is carried out by a lamp, the light of which is focused in a strip-like manner by means of cylinder lens.

5. Method according to one of the claims 1 to 4, in which in the method step c) an amorphous hydrogen containing silicon/germanium alloy a-Si₁₋ₓ Geₓ : H (1 > x ≥ 0) is deposited as a semi-conductor layer (HL) and in which the second irradiation (W2) is carried out such that the phase change leads to a microcrystalline alloy Si₁₋ₓ Geₓ by gassing out hydrogen.

6. Method according to one of the claims 1 to 4, in which a Chalcopyrite layer of the composition CuIn₁₋ₓGaₓ(S_{1-y}Se_{y})₂ (0 ≤ x, y ≤ 1) is produced and in which the second irradiation is carried out such that binary Cu₂Se or Cu₂S is enriched by gassing out volatile selenium compounds, whereby the low ohmic area (NB) of the semi-conductor layer (HL) is formed.

## Revendications

1. Procédé de montage en série d'une pile solaire en couche mince selon les étapes suivantes :
a) on dépose sur toute la surface une électrode de face avant transparente (FE) sur un substrat transparent (S),
b) on subdivise la couche d'électrode (FE) en n bandes électrodes (FE1, 2 ..., n),
c) on dépose sur toute la surface une couche semi-conductrice en couche mince (HL) à activité photovoltaïque,
d) on dépose sur toute la surface une électrode arrière (RE),
e) on effectue une première exposition à des rayons laser (W1) de la couche semi-conductrice (HL) à travers le substrat (S) et les bandes électrodes (FE1, 2, ..., n) parallèlement et à proximité d'un bord (EK) des bandes électrodes (FE1, 2, ..., n) à une longueur d'onde (λ1), pour laquelle la couche semi-conductrice montre une forte absorption, dans lequel procédé, dans une première zone (D1), une bande étroite de la couche semi-conductrice (HL) et de l'électrode arrière (RE) appliquée par-dessus est détachée et on obtient une structuration de la couche semi-conductrice en forme de bandes correspondant aux bandes électrodes (FE1, ..., n),
f) on effectue une seconde exposition (W2) de la couche semi-conductrice du côté du substrat avec une longueur d'onde (λ2) différente de celle des premiers rayons laser (W1), pour laquelle la couche semi-conductrice (HL) présente une absorption moindre que pour λ1 dans une seconde zone (D2), située entre la zone D1 et le bord mentionné (EK), dans laquelle l'électrode arrière (RE) chevauche la bande électrode (FE) respectivement adjacente de l'électrode avant, de manière à former par transition de phase dans la couche semi-conductrice une zone de faible impédance (NB) entre la bande électrode (FE) de l'électrode avant et l'électrode arrière (RE).

2. Procédé selon la revendication 1, dans lequel on effectue la seconde exposition aux rayons laser à une longueur d'onde (A2), la couche semi-conductrice (HL) présentant pour A1 une absorption plus élevée que pour λ2.

3. Procédé selon la revendication 1 ou 2, dans lequel on utilise, pour la première et la seconde exposition (aux rayons laser) (W2), un laser (L) de type Nd:YAG ou Nd:YLF à fréquence double, où la fraction non convertie de la longueur d'onde fondamentale IR du laser (L) est utilisée pour la seconde exposition (W2), et cette fraction du trajet des rayons est déclenchée pour la première exposition aux rayons laser (W1).

4. Procédé selon la revendication 1, dans lequel on effectue la seconde exposition (W2) avec une lampe, dont la lumière est focalisée en forme de bandes à l'aide d'une lentille cylindrique.

5. Procédé selon l'une quelconque des revendications 1 à 4, dans lequel on applique, à l'étape du procédé c), comme couche semi-conductrice (HL), un alliage de silicium/germanium amorphe contenant de l'hydrogène a-Si₁₋ₓGeₓ : H (1 > x ≥ 0) et dans lequel on effectue la seconde exposition (W2) de sorte que la transition de phase par dégagement d'hydrogène conduise à la formation d'un alliage de silicium/germanium microcristallin Si₁₋ₓGeₓ.

6. Procédé selon l'une quelconque des revendications 1 à 4, dans lequel on produit, comme couche semi-conductrice (HL), une couche de chalcopyrite de composition CuIn₁₋ₓGaₓ(S_{1-y}Se_{y})₂(0 ≤ x, y ≤ 1) et dans lequel on effectue la seconde exposition de manière que du Cu₂Se ou du Cu₂S binaire s'enrichisse par dégagement de composés de sélénium volatils en formant la zone de faible impédance (NB) de la couche semi-conductrice (HL).
